(19) Europäisches Patentamt
European Patent Office
Office européen des brevets

(11) **EP 3 002 875 B1**

(12) **EUROPEAN PATENT SPECIFICATION**

(45) Date of publication and mention
of the grant of the patent:
**10.06.2020 Bulletin 2020/24**

(51) Int Cl.:
*H03J 7/04* (2006.01)       *H04N 5/12* (2006.01)
*H04B 17/20* (2015.01)

(21) Application number: **15186934.4**

(22) Date of filing: **25.09.2015**

(54) **ERROR DETECTOR AND METHOD FOR DETECTING ERROR OF AN OSCILLATOR**

FEHLERERKENNUNG UND VERFAHREN ZUR ERKENNUNG EINES FEHLERS EINES OSZILLATORS

DÉTECTEUR D'ERREURS ET PROCÉDÉ DE DÉTECTION D'ERREUR D'UN OSCILLATEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.09.2014 KR 20140130536**

(43) Date of publication of application:
**06.04.2016 Bulletin 2016/14**

(73) Proprietor: **Samsung Electronics Co., Ltd.
Gyeonggi-do 16677 (KR)**

(72) Inventors:
• **HONG, Sang-min**
  **Gyeonggi-do (KR)**
• **LEE, Sang-keun**
  **Gyeonggi-do (KR)**

(74) Representative: **Taor, Simon Edward William et al
Venner Shipley LLP
200 Aldersgate
London EC1A 4HD (GB)**

(56) References cited:
GB-A- 2 351 403          JP-A- 2006 023 102
US-A- 4 156 255          US-A- 5 486 866
US-A- 6 057 699          US-A1- 2003 199 254
US-A1- 2004 041 947      US-A1- 2004 146 132

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

Methods, devices, apparatuses, and articles of manufacture consistent with the present disclosure relate to an error detector and a method for detecting an error of an oscillator, and more particularly, to an error detector and a method for detecting an error of an oscillator capable of detecting a defect of the oscillator used on a board using a broadcast signal.

Recently, an electronic device includes boards configured of various circuits. For example, there is a board embedded in a display device such as a television (TV). An oscillator generating a clock signal is present on the board. In a digital circuit, synchronous processing for processing a signal so as to be synchronized with the clock signal uses the oscillator. A typical kind of oscillator includes a voltage-controlled oscillator (VCO) and a crystal oscillator.

It is advantageous for the oscillator to accurately generate a signal having a desired frequency in order to ensure an accurate operation of an electronic circuit. Thus, it is advantageous to detect whether or not a defect is generated in the oscillator, because when a defect is generated in the oscillator, a phenomenon that a screen of the display device is distorted, or the like, is generated.

In order to detect a defect, an output of the oscillator has been measured using a scope, a frequency counter, and a spectrum analyzer, or the oscillator has been used without detecting the defect of the oscillator under the assumption that the defect will not cause a problem during operation. Relevant prior art such as US 4 156 255 A (HONGU MASAYUKI [JP] ET AL), describing a television receiver with two loops stably, and US 2004/146132 A1 (STASZEWSKI ROBERT B [US] ET AL), describing a built-in self-test circuit for a TV receiver system, do not address this problem.

Exemplary embodiments address the above disadvantages and other disadvantages not described above. However, the exemplary embodiments are not required to overcome the disadvantages described above, and an exemplary embodiment may not overcome any of the disadvantages described above.

It is an aspect to provide an error detector and a method for detecting an error of an oscillator capable of detecting a defect of the oscillator simultaneously with decoding a broadcast signal applied to a board using the broadcast signal without using a scope, a frequency counter, and a spectrum analyzer.

According to an aspect of an exemplary embodiment, there is provided an error detector as set out in claim 1.

The controller changes at least one of a phase and a frequency of the received oscillation signal within the frequency range so as to correspond to at least one of a phase and a frequency of the reference signal.

The controller may stop the change of the oscillation signal after a threshold time elapses.

The controller decides that the oscillator is normally operated when a color signal component value extracted from the reference signal is a threshold value.

The controller may generate a control command for displaying a corresponding graphical user interface (GUI) in a case in which the error is generated in the oscillator.

The frequency range may be one frequency range selected among a plurality of frequency ranges according to a user input.

The controller may change the oscillation signal of the oscillator in a sequence from a wide frequency range to a narrow frequency range within the selected frequency range so as to correspond to the reference signal.

The reference signal may be a color sub-carrier signal of a national television system committee (NTSC) signal or a phase alternation by line (PAL) signal.

The error detector may further comprise a level detector that is configured to detect an output level of the received oscillation signal, wherein the controller decides that the error is generated in the oscillator in a case in which the output level detected by the level detector is less than a threshold level, and decides whether the error is generated in the oscillator using the frequency range in a case in which the output level detected by the level detector is greater than or equal to the threshold level.

The error detector may further comprise a selector that is configured to select one of a plurality of oscillation signals of a plurality of oscillators, wherein the controller controls the receiver to receive one signal selected among the plurality of oscillator signals through the selector.

According to another aspect of an exemplary embodiment, there is provided a method for detecting an error of an oscillator as set out in claim 9.

In the changing, at least one of a phase and a frequency of the received oscillation signal is changed within the frequency range so as to correspond to at least one of a phase and a frequency of the reference signal.

The method may further comprise stopping the change of the oscillation signal after a threshold time elapses.

In the deciding, it is decided that the oscillator is normally operated when a color signal component value extracted from the reference signal is a threshold value.

The method may further comprise generating a control command for displaying a corresponding GUI in a case in which the error is determined to be present in the oscillator.

The frequency range may be one frequency range selected among a plurality of frequency ranges according to a user input.

In the changing, the oscillation signal of the oscillator may be changed in a sequence from a wide frequency range to a narrow frequency range within the selected frequency range so as to correspond to the reference signal.

The reference signal may be a color sub-carrier signal of a national television system committee (NTSC) signal or a phase alternation by line (PAL) signal.

The method may further comprise detecting an output level of the received oscillation signal, wherein in the deciding, it is decided that the error is generated in the oscillator in a case in which the detected output level is less than a threshold level, and it is decided whether the error is generated in the oscillator using the frequency range in a case in which the detected output level is greater than or equal to the threshold level.

The method may further comprise selecting one of a plurality of oscillation signals of a plurality of oscillators, wherein in the receiving, one signal selected among the plurality of oscillator signals is received.

The error may be a defect generated in the oscillator.

According to another aspect of an exemplary embodiment, there is provided a method for detecting a defect in an oscillator, the method comprising receiving an oscillation signal from the oscillator and a reference signal; using a phase locked loop (PLL) to control the oscillation signal to try to lock the oscillation signal to the reference signal in a frequency range; and detecting a defect in the oscillator based on whether lock occurs in the frequency range.

The scope of protection is defined by the accompanying set of claims.

The above and/or other aspects will be more apparent by describing certain exemplary embodiments with reference to the accompanying drawings, in which:

FIG. 1 is a schematic block diagram for describing a configuration of an error detector according to an exemplary embodiment;

FIG. 2 is a detailed block diagram for describing the configuration of the error detector of FIG. 1, according to the exemplary embodiment;

FIG. 3 is a view for describing a circuit configuration of the error detector of FIG. 1, according to the exemplary embodiment;

FIG. 4 is a view for describing a circuit configuration and a function of the error detector of FIG. 1, according to the exemplary embodiment;

FIG. 5 is a view for describing a case in which frequency LOCK and UNLOCK are made in the error detector according to the exemplary embodiment;

FIG. 6 is a view for describing a national television system committee (NTSC) signal configuration of each pixel line in a display screen according to the exemplary embodiment; and

FIGS. 7 to 9 are flow charts for describing a method for detecting an error of an oscillator according to various exemplary embodiments.

Hereinafter, exemplary embodiments will be described in detail with reference to the accompanying drawings.

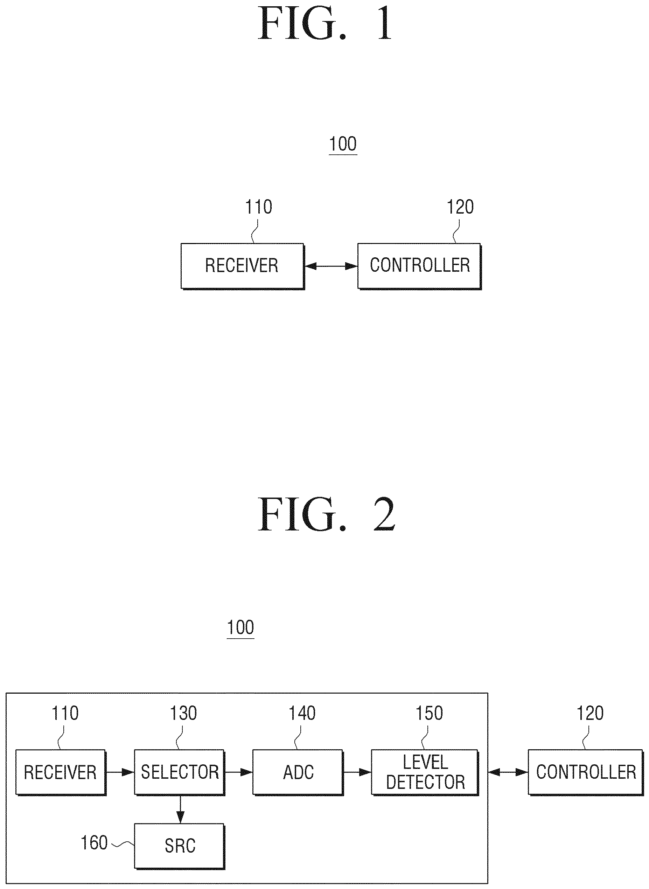

FIG. 1 is a block diagram schematically illustrating a configuration of an error detector according to an exemplary embodiment. Referring to FIG. 1, an error detector 100 includes a receiver 110 and a controller 120. The error detector 100 may be implemented in a television (TV), a set top box, or the like, receiving an analog broadcast signal. Even in the case of a digital TV receiving a digital broadcast signal, the error detector 100 may be implemented using a method for transmitting an analog signal for a remote diagnosis. In addition, the error detector 100 may be implemented in any electronic device capable of receiving an analog signal that may be used as a reference signal in addition to the broadcast signal, and is not limited to being implemented in the above-mentioned TV, or the like.

The receiver 110 receives an oscillation signal of an oscillator and a reference signal. For example, the oscillation signal may be a clock signal generated in the oscillator. The reference signal may be a broadcast signal. As examples of a format of the broadcast signal, there are a national television system committee (NTSC) signal, and a phase alternation by line (PAL) signal that is mainly used in Europe. This will be described below in detail. The receiver 110 receives color sub-carrier signals of these broadcast signals and transfers the color sub-carrier signals to the controller 120.

The controller 120 controls overall components and operations of the error detector 100. Particularly, the controller 120 changes the oscillation signal of the oscillator received in the receiver 110 within a frequency range so as to correspond to the reference signal. The frequency range may be preset. In addition, the controller 120 decides whether or not an error is present in the oscillator based on the changed oscillation signal. That is, the controller 120 decides whether or not a defect is present in the oscillator based on the changed oscillation signal.

In detail, the controller 120 changes at least one of a phase and a frequency of the oscillation signal within the frequency range to track the reference signal so that at least one of the phase and the frequency of the oscillation signal corresponds to at least one of a phase and a frequency of the reference signal. In the case in which the phase and the frequency of the oscillation signal are changed within the frequency range to track the reference signal so that the phase and the frequency of the oscillation signal are the same as those of the reference signal, it is called that LOCK is made.

To the contrary, in the case in which the reference signal may not be tracked so that the phase and the frequency of the oscillation signal are the same as those of the reference signal even though the phase and the frequency of the oscillation signal are changed within the frequency range, it is called that UNLOCK is made. The controller 120 may implement the tracking of the reference signal by the change of the oscillation signal through a digital phase locking loop (PLL) such as a burst lock PLL.

The controller 120 stops the change of the oscillation signal and extracts a color component value of the reference signal, when a threshold time elapses. The threshold time may be preset. In addition, the controller 120 decides whether or not the oscillator is normally operated based on the extracted color component value. The controller 120 changes the phase and the frequency of the oscillation signal using a feedback circuit in order to track the reference signal. Therefore, in order to decide whether a state is a state in which the LOCK is made by success of the tracking or a state is an UNLOCK state in which the tracking may not succeed even through continuous feedback, the controller 120 needs to stop the feedback circuit and analyze a component of the reference signal when the feedback circuit is stopped. However, the change of the oscillation signal may be very rapidly performed. For example, in the case of the NTSC signal, frequency tracking is completed in a time of about 1 ms. Therefore, the controller 120 sets a sufficient time for at least one of the phase and the frequency of the oscillation signal to correspond to at least one of the phase and the frequency of the reference signal, and stops the feedback circuit and extracts a parameter for deciding whether or not the error is present in the oscillator when the time elapses.

The controller 120 may generate a control command for displaying a corresponding graphical user interface (GUI) when it is decided that an error is present in the oscillator signal. The GUI may be a notification message notifying that an error is generated in a specific oscillator. As an example, in the case in which the error detector 100 is implemented in a device having a display, the controller 120 may control the display to display the GUI. As another example, in the case of a remote diagnosis, the controller 120 may also control a communicating circuit to transmit the notification message, or the like, to an external device performing the remote diagnosis.

The controller 120 may set a plurality of frequency ranges and sequentially set the frequency ranges to frequency ranges in which the oscillation signal may be changed in a sequence of wide frequency ranges, thereby deciding whether or not the LOCK is made. The controller 120 may recognize a specification in which the oscillator may be operated without an error by decreasing frequency ranges that may be sequentially changed. For example, when the TV has a specification that a screen output, or the like, is not affected even by a frequency variation up to 100 ppm, the controller 120 may directly set a frequency range to 100 ppm, or sequentially set a plurality of frequency ranges from 200 ppm, which is a wide range, to 150 ppm and 100 ppm, thereby deciding whether or not the LOCK is made. In the case in which the LOCK is made, it is called that SPEC IN of the frequency of the oscillator is made, and in the case in which the UNLOCK is made, it is called that SPEC OUT of the frequency of the oscillator is made.

A user may decide the SPEC IN and/or the SPEC OUT of the frequency of the oscillator using the broadcast signal through the error detector 100 as described above. Since the case in which the SPEC OUT is made corresponds to the case in which the oscillator may not be appropriately operated, the error detector 100 may decide that the error is generated in the oscillator and provide a notification message to the user for notifying the user that an individual oscillator or an entire board needs to be replaced.

FIG. 2 is a block diagram illustrating the configuration of the error detector 100 according to an exemplary embodiment in more detail. Referring to FIG. 2, the error detector 100 includes the receiver 110, the controller 120, a selector 130, an analog to digital converter (ADC) 140, a level detector 150, and a sample rate converter (SRC) 160.

The receiver 110 receives the reference signal, and the oscillation signal of the oscillator. In some exemplary embodiments, the reference signal may be a color sub-carrier signal of national television system committee (NTSC) or phase alternation by line (PAL). The NTSC scheme is a broadcast signal transmitting scheme of faithfully transmitting three primary colors (R, G, and B) with respect to large area signals, accurately transmitting a luminance of a color with respect to a medium area signal, and transmitting only a luminance signal with respect to small area signals. In the NTSC scheme, different signals are transmitted depending on areas using the fact that human eyes do not substantially feel a color with respect to a small area. In the NTSC scheme, it is advantageous to have a high performance of a transmission circuit for the purpose of high level band compression. The PAL scheme is a color TV broadcasting scheme developed in Germany. The PAL scheme has a feature that a color change depending on a signal transmission system is less than that of the NTSC scheme and a high level specification is not required in broadcasting equipment. The PAL scheme is a broadcast signal transmission scheme that is mainly used in Europe.

The selector 130 may select one of oscillation signals of a plurality of oscillators. The plurality of oscillators may be present on one board, and the selector 130 may select a specific oscillator of the plurality of oscillators and transfer an oscillation signal to the controller 120. For example, the selector 130 may be implemented through a multiplexer (MUX). The MUX is a device allowing a plurality of signals to be transmitted through one channel. When the MUX is used, a signal that is to be transmitted may be selected. For example, an MUX having eight inputs may select a specific input by three bits of selection command. The selector 130 may detect whether or not an error is present in the specific oscillator on the board on which the plurality of oscillators are present.

The ADC 140 converts an analog signal into a digital signal. According to some exemplary embodiments, the ADC 140 converts the oscillation signal of the oscillator, which is the analog signal received in the receiver 110, into a digital signal. The ADC 140 converts the signal into the digital signal in order for a level detector 150 to be described below to compare the digital signal with an output level. For example, the ADC 140 may be implemented by an analog to digital converter circuit (ADC) and a comparator. The output level may be preset.

The level detector 150 detects an output level of the oscillator. The level detector 150 may detect the output level of the oscillator based on the oscillation signal converted into the digital signal. In addition, the level detector 150 may directly compare the detected output level with a threshold level to decide whether or not the error is generated in the oscillator, instead of transmitting the detected output level to the controller 120. The threshold level may be preset. In a complementary metal oxide semiconductor (CMOS), since the oscillator is not operated in the case in which an output of the oscillator is lower than a threshold level, even though a frequency is accurately output, the oscillator may not perform a function. Therefore, before the error of the oscillator is detected using the frequency, the level detector 150 may primarily detect the output level to screen the oscillator in which the error is generated.

The SRC 160 converts a sampling rate to tune frequencies of the reference signal and the oscillation signal of the oscillator to each other. The SRC is an abbreviation of a sample rate converter. After the frequencies of the reference signal and the oscillation signal coincide with each other through the SRC 160, the controller 120 changes the oscillation signal so that phases of the two signals become the same as each other using a digital PLL. The sampling rate is determined based on the frequencies of the reference signal and the oscillation signal. As an example, in the case in which a frequency of the oscillation signal is 24 MHz, when an NTSC signal having a frequency of 3.58 MHz is the reference signal, the SRC 160 performs sampling approximately eight times. That is, the SRC 160 uses a 8X sampling rate. As another example, when a PAL signal having a frequency of 4.43 MHz is the reference signal, the SRC 160 performs sampling approximately six times. That is, the SRC 160 uses a 6X sampling rate. As described above, the SRC 160 allows the frequencies of the received reference signal and the oscillation signal to coincide with each other and transmits them to the controller 120.

In addition, the error detector 100 may further include a communication circuit, a display, and an interface circuit.

The communication circuit allows communication with an external device to be performed. When it is to be detected whether or not the error is generated in the oscillator through remote diagnosis, the communication circuit transmits and receives data for the remote diagnosis, or the like, to and from the external device. The communication circuit may comprise a wireless or wired communication module. The communication circuit may use high definition multimedia interface (HDMI), low voltage differential signaling (LVDS), local area network (LAN), and the like, as a wired communication scheme. In addition, the communication circuit may use various schemes such as near field communication (NFC), wireless LAN (WLAN), infrared (IR) communication, Zigbee communication, WiFi, Bluetooth, and the like, as a wireless communication scheme. For example, in the case in which the error detector 100 is implemented in a TV or a set top box, the communication circuit may receive a remote diagnosis control command through a path through which the broadcast signal is received.

The display displays a GUI indicating whether or not an error is generated in the oscillator. As an example, in the case in which the error detector 100 is implemented in a TV, the display may be a display panel of the TV. The display may be implemented by various display technologies such as a liquid crystal display (LCD), an organic light-emitting diode (OLED), an E-paper, a plasma display panel (PDP), a vacuum fluorescent display (VFD), a field emission display (FED), an electro luminescence display (ELD), and the like. As another example, in the case in which the error detector 100 is implemented in a set top box, the display may be a board displaying a channel number, or the like. Since the set top box may display an error code, or the like, the user may recognize whether or not the error is generated in the oscillator through a displayed message.

The interface circuit performs a function of receiving a user input. In some exemplary embodiments, the interface circuit may receive a user input setting the plurality of frequency ranges. The interface circuit may be implemented by a remote controller, a touch screen, a keypad, or the like. In addition, the interface circuit may receive the user input in a scheme of displaying a UI on the display. As another example, the interface circuit may receive a selection command for selecting an oscillator of which an error is to be detected among the plurality of oscillators. The interface circuit may transmit the received selection command to the selector 130 through the controller 120 or transmit the received selection command directly to the selector 130.

The controller 120 controls the receiver 110, the selector 130, the ADC 140, the level detector 150, and the SRC 160. The controller 120 controls other components that may be generally included in the error detector 100 although not illustrated or components that may be additionally included in the error detector 100, such as the communication circuit, the display, and the interface circuit. The controller 120 changes the oscillation signal within a frequency range so as to correspond to the received reference signal. The frequency range may be preset. In addition, the controller 120 decides whether or not the error is generated in the oscillator based on the changed oscillation signal.

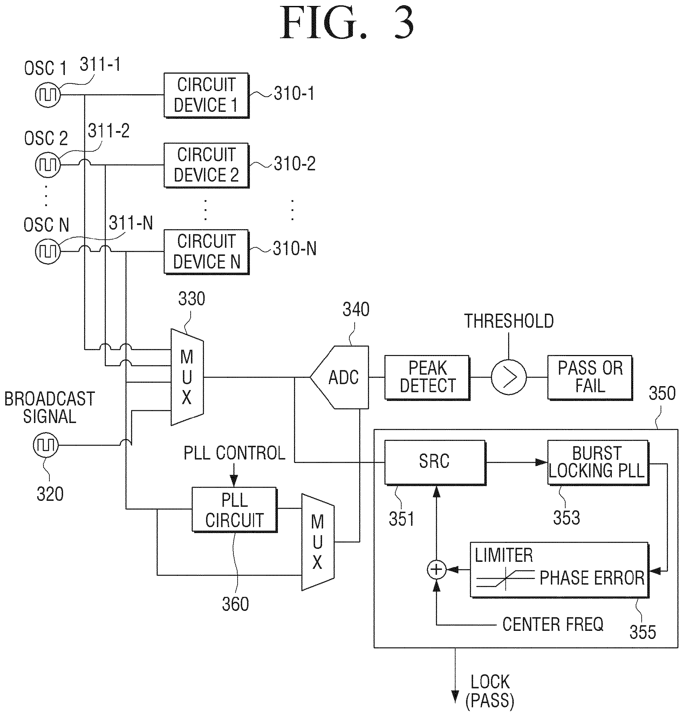

A detailed operation of the controller 120 will be described below with reference to FIGS. 3 to 6.

FIG. 3 is a view for describing a circuit configuration of the error detector 100 according to the exemplary embodiment. For example, as illustrated in FIG. 3, a plurality of circuit devices (Circuit Devices 1, 2, ..., N) 310-1, 310-2, ..., 310-N may be present on the board, and oscillators (OSC 1, OSC 2, ..., OSC N) 311-1, 311-2, ..., 311-N that may generate clock signals are present with the circuit devices, respectively. In some exemplary embodiments, the oscillators may be provided within the circuit devices. In other exemplary embodiments, the oscillators may be provided separately from the circuit devices. Oscillation signals generated in the plurality of oscillators 311-1, 311-2, ..., 311-N are input to a MUX 330. The MUX 330 performs a role of the selector 130. The controller 120 controls the MUX 330 to select one of the oscillation signals generated in the plurality of oscillators 311-1, 311-2, ..., 311-N. The MUX 330 performs a function of receiving a plurality of inputs, selecting one of the plurality of inputs, and outputting the selected input, but also performs a function of multiplexing the plurality of inputs and transmitting the multiplexed inputs to one channel. Therefore, the MUX 330 may receive a broadcast signal 320 that is to be used as the reference signal and transmit the broadcast signal together with the oscillation signal to the controller 120.

A signal input to an ADC 340 of FIG. 3 will be described. According to some exemplary embodiments, the controller 120 controls the level detector 150 to detect an output level of the oscillation signal. In addition, the controller 120 compares the detected output level of the oscillation signal with a threshold level to decide whether or not an error is generated in the oscillator. The threshold level may be preset. The oscillation signal is input to the ADC 340, such that it is converted into a digital signal. Since an output level comparison is not performed on an analog signal, the controller 120 controls the ADC 340 to convert the oscillation signal into the digital signal. Since the ADC 340 performs a function of the ADC 140, a comparator may be used instead of the ADC 340, as described above. In the case in which the output level of the oscillation signal is less than a threshold level, the controller 120 decides that an error is generated in the oscillator. The reason is that the oscillator may not be operated on the CMOS when an output of a threshold output level or more is not present regardless of whether or not an accurate frequency may be generated. In the case in which the output level of the oscillation signal is the threshold level or more, the controller 120 performs a method for detecting an error of an oscillator using a frequency to be described below. The controller 120 may screen the oscillator in which the error is generated using the output level.

In some exemplary embodiments, the controller 120 may change the oscillation signal within a frequency range so as to correspond to the reference signal. For example, the controller 120 may be implemented like a block 350 including an SRC 351, a burst locking PLL 353, a limiter 355, and the like, of FIG. 3. The received reference signal 320 and the selected one oscillation signal 311 are first input to the SRC 351. As described above, the controller 120 controls the SRC 351 to convert a sample rate to allow frequencies of the reference signal and the oscillation signal to coincide with each other. The controller 120 allows phases of the reference signal and the oscillation signal to coincide with each other using the burst locking PLL 353. However, the frequencies and the phases do not coincide with each other at an initial time, but attempt to coincide with each other through feedback by the controller 120. This attempt is called frequency tracking, and in the case in which the frequencies and the phases coincide with each other, it is called that LOCK is made. Setting of a range of a trackable frequency by the controller 120 and a method for deciding the error of the oscillator by the controller 120 will be described in detail below.

Referring to FIG. 3, it may be confirmed that a PLL circuit 360 is additionally present before the reference signal and the oscillation signal are input to the SRC 351. The PLL circuit 360 performs a function of adjusting the frequency of the input oscillation signal to thereby be tuned to a frequency used in the SRC 351. When a target is only a single oscillator, it is sufficient that the frequency of the SRC 351 is set to be the same as that of the single oscillator, and thus, the PLL circuit 360 as described above may be omitted.

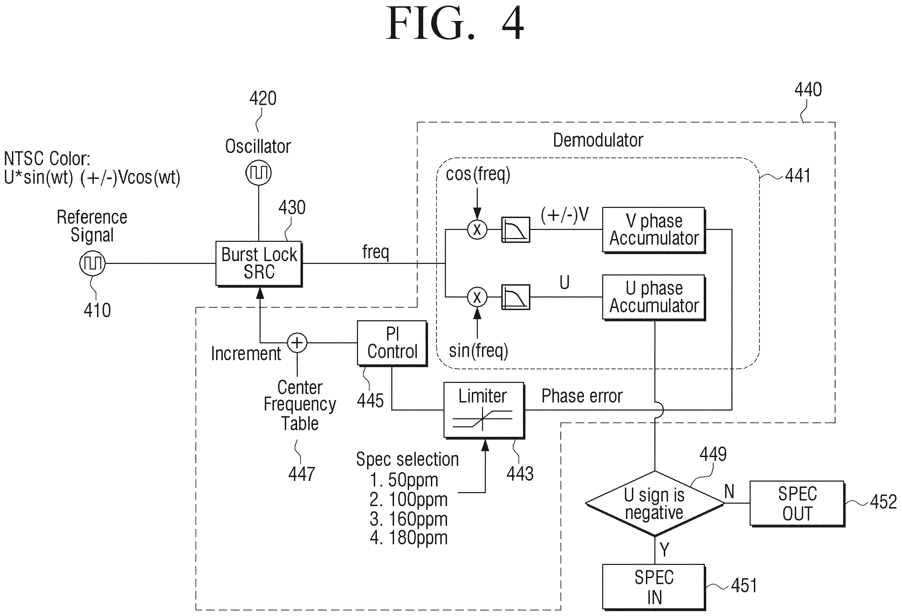

FIG. 4 is a view for describing a circuit configuration and a function of an error detector according to an exemplary embodiment. Particularly, FIG. 4 is a view illustrating a circuit portion performing a function of detecting an error using a frequency in detail.

As illustrated in FIG. 4, an oscillation signal 420 of an oscillator and a reference signal 410 are input to a burst lock SRC 430. Here, a case in which the reference signal 410 is an NTSC color sub-carrier signal will be described by way of example. However, the reference signal 410 is not limited thereto, but may be a PAL signal, an analog signal provided for a remote diagnosis, or the like. The reason why the NTSC signal, which is a broadcast signal, is used as the reference signal 410 is that reliability of the broadcast signal is high. The NTSC color sub-carrier signal has the following format (see equation below). A sign in front of Vcos(wt) is changed per pixel line of the display panel. This will be described in detail below.

$$U \sin(\omega t)(+/-)V \cos(\omega t)$$

The controller 120 controls the burst lock SRC 430 so that frequencies of the reference signal 410 and the oscillation signal 420 coincide with each other. The controller 120 may control the burst lock SRC 430 to convert a sample rate, thereby changing the frequency.

Referring to FIG. 4, a signal processed by the burst lock SRC 430 is input to a digital PLL 440. For example, as illustrated in FIG. 4, several circuits 441, 443, 445, and 447 may be gathered to thereby be implemented as one system on chip (SoC). The controller 120 may control a demodulator 441 to perform a function of changing a phase of the oscillation signal simultaneously with decoding the broadcast signal. In detail, the demodulator 441 separates a U component and a V component of the NTSC signal from each other. The controller 120 may determine whether a sign of the U component is negative (449). When the sign is negative (449-Y), the controller may determine that SPEC IN 451 is achieved. When the sign is not negative (449-N), the controller may determine that SPEC OUT 452 is present. In an ideal case, signs in front of Vcos(wt) in broadcast signals each input to one pixel line and a pixel line positioned directly beneath one pixel line in the display panel are different from each other. For example, when a broadcast signal input to a first pixel line is Usin(wt) + Vcos(wt), a broadcast signal input to a second pixel line is Usin(wt) - Vcos(wt). That is, a phase difference between broadcast signals input to two adjacent pixel lines is 180 degrees. The controller 120 decides whether or not an error is generated in a phase using a V phase analyzed in the demodulator 441. The controller 120 changes the oscillation signal within a threshold frequency range in order to allow phases to coincide with each other. The controller 120 controls a limiter 443 to change the oscillation signal within a frequency range. In some exemplary embodiments, the controller 120 may control the limiter 443 to change the oscillation signal only within a preset frequency range. The controller 120 may set a frequency range to an error range allowable in an electronic device. Each electronic device has a range in which it may be normally operated even though an error is generated in the frequency of the oscillation signal. The allowable error range is called Spec. A unit of this frequency range is ppm. For example, a frequency range of 500 ppm in a signal having a frequency of 3.5 MHz is calculated as follows.

$$(3.5 \text{ X } 10^6 \text{ Hz}) \text{ X } (1 - 500 \text{ X } 10^6) \sim (3.5 \text{ X } 10^6 \text{ Hz}) \text{ X } (1 + 500 \text{ X } 10^6)$$

That is, the frequency range becomes a range of 3.49825 MHz to 3.50175 MHz. Therefore, when a phase difference is generated within 3.5 kHz, the reference signal may be tracked in the frequency range of 500 ppm, such that the LOCK may be made.

The controller 120 controls a PI controller 445 to decrease the decided error. The PI controller 445 connects and uses an integral control integrating an error signal to generate a control signal in parallel with a proportional control. The PI controller 445 is mainly used in a feedback circuit. Since the PI controller 455 is a general circuit, a detailed description therefor will be omitted.

A center frequency table 447 illustrated in FIG. 4 notifies the controller 120 of a w value of the reference signal 410, that is, a frequency, thereby allowing the controller 120 to decide how many divisions to perform on the oscillation signal of the oscillator.

According to an exemplary embodiment, the controller 120 changes at least one of the phase and the frequency of the received oscillation signal 420 within the frequency range through the feedback circuit so as to correspond to at least one of the phase and the frequency of the reference signal 410, as described above. In the case in which the LOCK is not possible, even though the feedback circuit is executed for a long period of time, the phases of the oscillation signal 420 and the reference signal 410 do not correspond to each other. Therefore, after a time enough to make the LOCK through the frequency tracking elapses, the controller 120 stops the feedback circuit, and extracts a U value among signal components of the reference signal 410 to decide whether or not the error is generated in the oscillator. For example, in the case of an NTSC signal, it has been known that a time of approximately 1 ms is used for the LOCK to be made. That is, a time for changing the oscillation signal 420 so that the frequency and the phase of the oscillation signal 420 coincide with those of the reference signal 410 is about 1 ms. The controller 120 performs a control to stop the change of the oscillation signal 420 when a threshold time elapses. The threshold time may be preset. In addition, the controller 120 decides that the oscillator is normally operated when the U value, which is a color signal component value extracted from the reference signal 410 at a point in time in which the change of the oscillation signal 420 is stopped, is a threshold value. The threshold value may be preset. When the LOCK of the oscillation signal 420 is made, that is, when the oscillator generates the oscillation signal 420 within an allowable frequency error range so as to correspond to the reference signal 410, the controller 120 decides that SPEC IN is made. To the contrary, in the case in which the oscillation signal 420 does correspond to the reference signal 410 due to the change within the frequency range, such that the UNLOCK is made, the controller 120 decides that SPEC OUT is made. Since the U value becomes a negative number in the case in which the SPEC IN is made, the controller 120 may decide whether or not the error is generated in the oscillator based on whether or not the U value is a threshold value set to a negative number. The threshold value may be preset. As another example, when V components of two adjacent pixel lines are added to each other to become 0, that is, when a phase difference between the V components of the two adjacent pixel lines is 180 degrees, the controller 120 decides that the oscillator is normally operated. Therefore, in the case of using the V components, the controller 120 may decide whether or not the error is generated depending on whether or not a value obtained by adding the V components of the two adjacent pixel lines to each other is 0, which is a threshold value.

According to an exemplary embodiment, in the case in which it is decided that the error is present in the oscillator, the controller 120 generates a control command for displaying a corresponding GUI. As an example, the controller 120 may control the display to display a notification message notifying that the error is generated. As another example, in the case of the remote diagnosis, the controller 120 may control the communication circuit to transmit a control command for allowing a GUI notifying an external diagnosing device that the error is generated to be displayed. In addition, the controller 120 may generate a control command for displaying a corresponding GUI even in the case in which the oscillator is normally operated. In the case in which error detection is performed on the plurality of oscillators, the controller 120 may control the display, or the like, to collect error detection results for the plurality of oscillators and provide the collected error detection results as one GUI.

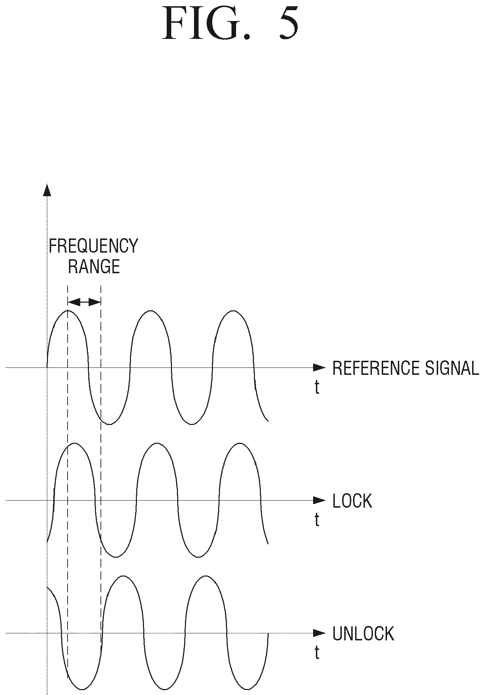

FIG. 5 is a view for describing the case in which frequency LOCK and UNLOCK are made in an error detector according to an exemplary embodiment. Referring to FIG. 5, a sine waveform of a reference signal is illustrated at the uppermost portion. In addition, a frequency range is set. For example, the controller 120 may limit a frequency range using a circuit such as a limiter, or the like. An oscillation signal illustrated at the middle portion of FIG. 5 corresponds to an oscillation signal in the case in which LOCK is possible. In this case, the controller 120 changes the oscillation signal within the set range, thereby making it possible to allow a waveform of the oscillation signal to coincide with that of a reference signal. That is, the controller 120 may change the oscillation signal so as to correspond to at least one of a phase and a frequency of the reference signal. An oscillation signal illustrated at the lowermost portion of FIG. 5 corresponds to an oscillation signal in the case of UNLOCK in which LOCK is impossible. In this case, even though the controller 120 uses the feedback circuit, the controller 120 is not able to change the oscillation signal of which a phase coincides with that of the reference signal illustrated at the uppermost portion. As described above, when the LOCK is made, the oscillator is normally operated, and the controller 120 may recognize whether or not the oscillator is normally operated by deciding whether or not the U value is a threshold value in the case of the NTSC signal.

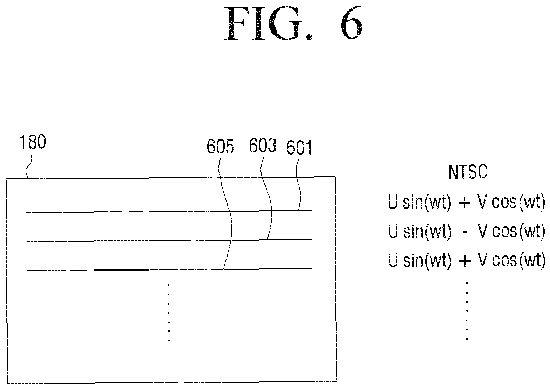

FIG. 6 is a view for describing a national television system committee (NTSC) signal configuration of each pixel line in a display screen according to an exemplary embodiment. In FIG. 6, a display panel 180 of a TV will be described by way of example. A plurality of pixel lines 601, 603, and 605 are present in a display. The controller 120 transmits the same broadcast signal to each pixel line in a horizontal direction. For example, in the case of the NTSC signal, when a signal having a Usin(wt) + Vcos(wt) form is applied to a first pixel line 601, a signal having a Usin(wt) - Vcos(wt) form is applied to a second pixel line 603. In addition, a signal having a Usin(wt) + Vcos(wt) form, which is the same as the signal applied to the first pixel line 601, is again applied to a third pixel line 605. Therefore, in an ideal case, when the signal of the first pixel line 601 and the signal of the second pixel line 603 are added to each other, a value of V components becomes 0. In addition to the method for deciding whether or not the error is generated in the oscillator through whether or not the U value is the negative number, the controller 120 may decide whether or not the error is generated in the oscillator through whether or not the V components of the two adjacent pixel lines are added to each other to become 0. Therefore, the controller 120 may set the threshold value to a negative number in the case of using the U value and set the threshold value to 0 in the case of using the V value.

The user may detect a defect of the oscillator used on the board using the broadcast signal as the reference signal through the error detector as described above. In addition, the user may decide whether or not the error is generated in the oscillator using an existing circuit present on the board without configuring a separate scope, a separate frequency counter, and the like.

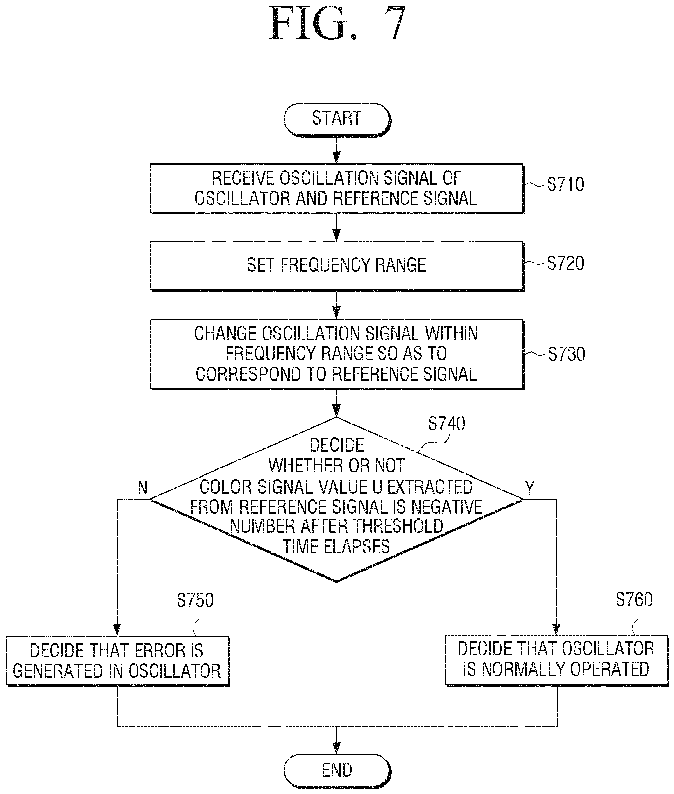

Hereinafter, a method for detecting an error of an oscillator will be described with reference to FIGS. 7 to 9.

FIG. 7 is a flow chart for describing the method for detecting an error of an oscillator according to an exemplary embodiment. The error detector 100 receives the oscillation signal of the oscillator and the reference signal (S710). In addition to the case of receiving an oscillation signal from a single oscillator, there is a method for selecting and receiving one of oscillation signals of a plurality of oscillators. The error detector 100 may use the broadcast signal as the reference signal. Since the broadcasting signal is a signal having high reliability due to the fact that a frequency thereof is constant, the broadcasting signal may be used as the reference signal. As an example, the reference signal may be a color sub-carrier signal of NTSC or PAL. As another example, in the case of a digital TV that does not receive an analog signal, an analog signal that is to be used as the reference signal may be separately transmitted and used to detect the error.

The error detector 100 sets a frequency range (S720). The frequency range that is set is determined in consideration of an error range allowable in each electronic device In the case in which the oscillator is actually operated, the error cannot be generated. Therefore, each electronic device has an allowable error range in which a problem is not generated in an operation thereof. The error detector 100 changes the oscillation signal within the frequency range so as to correspond to the reference signal (S730). In detail, the error detector 100 changes the oscillation signal using the feedback circuit so as to coincide with at least one of the phase and the frequency of the reference signal, thereby tracking the reference signal. In the case in which the tracking of the reference signal succeeds, it is called that the LOCK is made, and when the LOCK is made, the U value among components of the NTSC signal appears as a negative number. Therefore, the error detector 100 decides whether or not the U value extracted from the reference signal is a negative number (S740) after a threshold time in which a time for tracking the reference signal elapses. The error detector 100 may set the threshold value to the negative number.

When the U value extracted from the reference signal is not the negative number, which is set as the threshold value (S740-N), the error detector 100 decides that an error is generated in the oscillator (S750). To the contrary, when the U value extracted from the reference signal is the negative number, which is set as the threshold value (S740-Y), the error detector 100 decides that the oscillator is normally operated (S760). As another example, the error detector 100 may decide that the oscillator is normally operated when V value components of the NTSC signals applied to two adjacent pixel lines that are added to each other become 0. That is, alternatively, the error detector 100 may add the V value components of the NTSC signals of two adjacent pixel lines together, and determine if the result is equal to 0. In addition, the error detector 100 may generate a GUI notifying whether or not the error is generated in the oscillator.

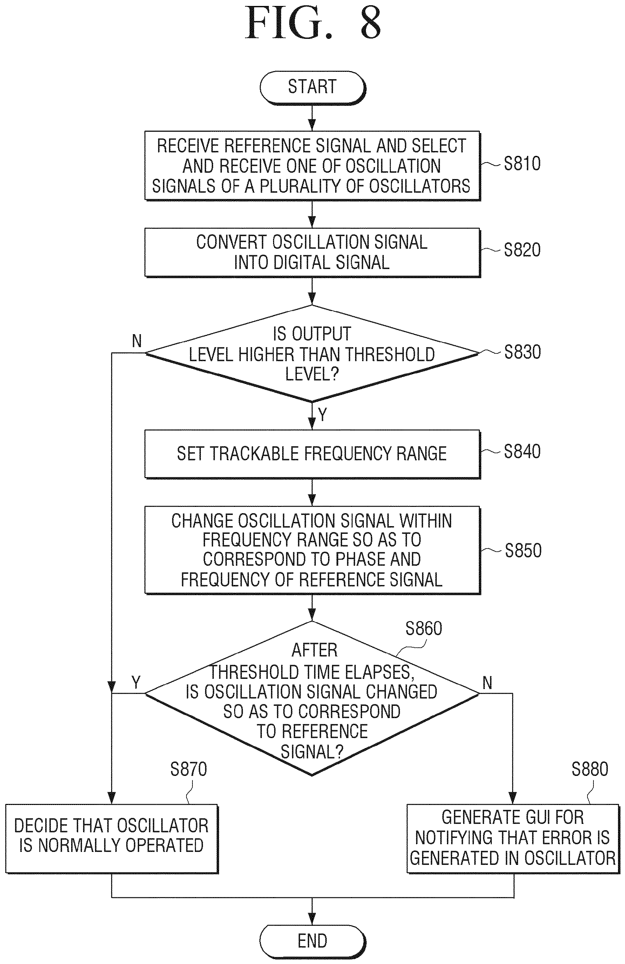

FIG. 8 is a flow chart for describing the method for detecting an error of an oscillator according to another exemplary embodiment. In FIG. 8, an example in which error detection is primarily performed using an output level and is secondarily performed using a frequency will be described. The error detector 100 receives the reference signal, and selects and receives one of the oscillation signals of the plurality of oscillators (S810). The error detector 100 may sequentially use the oscillation signals of the plurality of oscillators present on the board one by one using the MUX, or the like, or use only an oscillation signal of the selected oscillator to detect the error.

The error detector 100 converts the selected and received oscillation signal into a digital signal (S820). The oscillation signal, which is an analog signal, is converted into the digital signal in order to primarily detect an output level. Since an operation is not performed when the output level of the oscillation signal is lower than a threshold level, even though the oscillator accurately outputs a frequency, a determination is made as to whether the error is generated in the oscillator. In order to convert the oscillation signal into the digital signal, the error detector 100 may use an ADC, a comparator, or the like. The error detector 100 detects the output level of the oscillation signal and decides whether or not the output level of the oscillation signal is higher than a threshold level (S830). When the detected output level of the oscillation signal is not higher than the threshold level (S830-N), the error detector 100 decides that the oscillator is not normally operated (S880) and directly generates a GUI notifying that the error is generated in the oscillator without performing the error detection using the frequency. On the other hand, when the detected output level of the oscillation signal is higher than the threshold level (S830-Y), the error detector 100 decides that the oscillator passes through a primary level test, such that the error detector 100 enters a method for detecting an error using the frequency.

The error detector 100 sets the trackable frequency range (S840). The error detector 100 changes the oscillation signal within the frequency range so as to correspond to the phase and the frequency of the reference signal (S850). The error detector 100 may change the oscillation signal using the feedback circuit including the SRC, the digital PLL, and the like. For example, the error detector 100 detects a phase difference between the reference signal and the oscillation signal and decreases the phase difference using the feedback circuit. After a threshold time used to track the reference signal using the feedback circuit elapses, the error detector 100 decides whether or not the oscillation signal is changed so as to correspond to the reference signal (S860). When the oscillation signal is changed so that at least one of the phase and the frequency thereof coincides with at least one of the phase and the frequency of the reference signal (S860-Y), the error detector 100 decides that the oscillator is normally operated (S870). The error detector 100 may generate a GUI for notifying that the oscillator is normally operated even in the case in which it is decided that the oscillator is normally operated. On the other hand, when the phases and the frequencies of the reference signal and the oscillation signal do not coincide with each other (S860-N), the error detector 100 decides that the error is generated in the oscillator. Therefore, the error detector 100 generates a GUI for notifying that the error is generated in the oscillator (S880). As another example, the error detector 100 may also transmit a notification message for notifying that the error is generated to an external device performing the remote diagnosis.

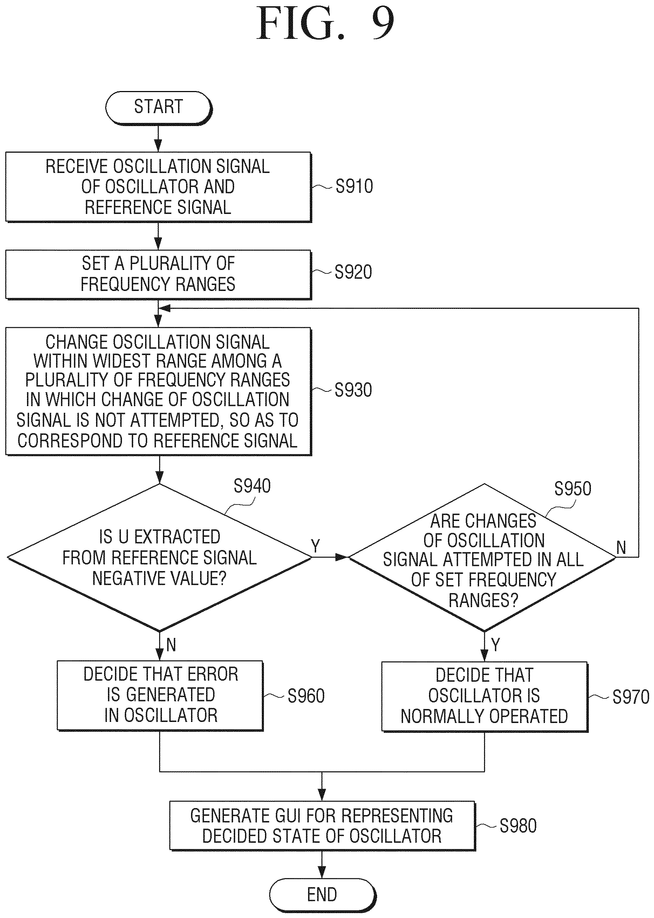

FIG. 9 is a flow chart for describing the method for detecting an error of an oscillator according to another exemplary embodiment. FIG. 9 illustrates an example in which a plurality of frequency ranges are set and are sequentially applied in a sequence of wide frequency ranges. Similar to the above-described exemplary embodiments, the error detector 100 receives the oscillation signal of the oscillator and the reference signal (S910). The error detector 100 may set the plurality of frequency ranges (S920). The plurality of frequency ranges are set, thereby making it possible to recognize a frequency range in which the oscillator may be operated. The error detector 100 may set a plurality of frequency ranges input by the user, or alternatively may receive one frequency range input by the user and narrow the frequency range at an interval to attempt error detection on a plurality of frequency ranges.

The error detector 100 changes the oscillation signal within the widest range among the plurality of frequency ranges in which the change of the oscillation signal is not attempted, so as to correspond to the reference signal (S930). For example, in the case in which the plurality of frequency ranges of 50 ppm, 100 ppm, and 300 ppm are set, when the oscillation signal is already changed with respect to 300 ppm, the error detector 100 will attempt to change the oscillation signal with respect to 100 ppm, which is a second widest frequency range, and then to 50 ppm which is the third widest range, and so on.

When it is decided that the oscillator is normally operated in a wider frequency range, the error detector 100 gradually narrows the frequency range to recognize a frequency range in which the oscillator may be operated. The error detector 100 decides that the oscillator is normally operated when a color component value extracted from the reference signal is a threshold value. The threshold value may be preset. For example, in the case of the U value, the threshold value may be a negative number. In the case in which the U value extracted from the reference signal, which is the NTSC broadcast signal, is the negative value (S940-Y), the error detector 100 decides whether or not changes of the oscillation signal are attempted in all of the set frequency ranges (S950). When frequency ranges in which the changes of the oscillation signal are not yet attempted remain (S950-N), the error detector 100 again returns to S930 to change the oscillation signal to the next widest range. When the changes of the oscillation signal are attempted in all of the frequency ranges (S950-Y), the error detector 100 decides that the oscillator is normally operated even in the narrowest frequency range (S970). Then, the error detector 100 generates a GUI for notifying the decided state of the oscillator (S980), in this case that the oscillator is normally operated even in the narrowest frequency range.

On the other hand, in the case in which the error detector 100 decides that the U value extracted from the reference signal, which is the NTSC broadcast signal, is not the negative value (S940-N), the error detector 100 decides that an error is generated in the oscillator in a frequency range when the U value is extracted (S960). The error detector 100 generates a GUI for notifying the decided state of the oscillator (S980), in this case that notifies in which of the plurality of frequency ranges the error is generated.

The user may decide whether or not the error is generated in the oscillator and in which frequency range the oscillator may be operated, through the method for detecting an error of an oscillator as described above.

In addition, program codes for performing the method for detecting an error according to various exemplary embodiments as described above may be stored in various types of recording media. In detail, the program codes may be stored in various types of recording media that is readable by a terminal, such as a random access memory (RAM), a flash memory, a read only memory (ROM), an erasable programmable ROM (EPROM), an electronically erasable programmable ROM (EEPROM), a register, a hard disk, a removable disk, a memory card, a universal serial bus (USB) memory, a compact-disk (CD) ROM, and the like.

According to various exemplary embodiments as described above, the error detection using the frequency of the oscillator may be performed using the broadcast signal as the reference signal. Therefore, the user uses circuits already provided on the board, thereby making it possible to conveniently detect the error of the oscillator.

Although various exemplary embodiments have been illustrated and described hereinabove, the present inventive concept is not limited to the above-mentioned specific exemplary embodiments, but may be variously modified by those skilled in the art without departing from the scope as disclosed in the accompanying claims. These modifications should also be understood to fall within the scope of the claims.

**Claims**

1. An error detector comprising:

    a receiver (110) arranged to receive an oscillation signal of an oscillator and a reference signal comprising a color sub-carrier signal of a broadcast television signal; and
    a controller (120) arranged to change the oscillation signal within a frequency range so as to correspond to the reference signal,
    wherein the controller is arranged to change at least one of a phase and a frequency of the received oscillation signal within the frequency range so as to track the reference signal so that at least one of the phase and the frequency of the oscillation signal corresponds to at least one of a phase and a frequency of the reference signal, and
    wherein the controller is arranged to determine whether or not an error is generated in the oscillator by extracting a component value corresponding to a color signal from the reference signal and comparing the component value to a preset value.

2. The error detector as claimed in claim 1, wherein the controller is arranged to stop the change of the oscillation signal when a threshold time elapses.

3. The error detector as claimed in any one of claims 1 to 2, wherein the controller is arranged to generate a control command for displaying a corresponding graphical user interface, GUI, in a case in which the error is present in the oscillator.

4. The error detector as claimed in any one of claims 1 to 3, wherein the frequency range is one frequency range selected among a plurality of frequency ranges according to a user input.

**5.** The error detector as claimed in claim 4, wherein the controller is arranged to change the oscillation signal of the oscillator in a sequence from a wide frequency range to a narrow frequency range within the selected frequency range so as to correspond to the reference signal.

**6.** The error detector as claimed in any one of claims 1 to 5, wherein the reference signal is a color sub-carrier signal of a national television system committee, NTSC, signal or a phase alternation by line, PAL, signal.

**7.** The error detector as claimed in any one of claims 1 to 6, further comprising a level detector (150) arranged to detect an output level of the received oscillation signal,
wherein the controller is arranged to decide that the error is generated in the oscillator in a case in which the output level detected by the level detecting unit is less than a threshold level, and to determine whether or not the error is generated in the oscillator using the frequency range in a case in which the output level detected by the level detector is greater than or equal to the threshold level.

**8.** The error detector as claimed in any one of claims 1 to 7, further comprising a selector (130) arranged to select one of a plurality of oscillation signals of a plurality of oscillators,
wherein the controller is arranged to control the receiver to receive one signal selected among the plurality of oscillator signals through the selector.

**9.** A method for detecting an error of an oscillator, the method comprising:

receiving an oscillation signal of the oscillator and a reference signal comprising a color sub-carrier signal of a broadcast television signal;
changing the oscillation signal within a frequency range so as to correspond to the reference signal; and
determining whether or not an error is generated in the oscillator by extracting a component value corresponding to a color signal from the reference signal and comparing the component value to a preset value,
wherein in the changing, at least one of a phase and a frequency of the received oscillation signal is changed within the frequency range so as to track the reference signal so that at least one of the phase and the frequency of the oscillation signal corresponds to at least one of a phase and a frequency of the reference signal.

**10.** The method as claimed in claim 9, further comprising stopping the change of the oscillation signal when a threshold time elapses.

**11.** The method as claimed in any one of claims 9 to 10, further comprising generating a control command for displaying a corresponding GUI in a case in which the error is present in the oscillator.

**Patentansprüche**

**1.** Fehlerdetektor, der Folgendes umfasst:

einen Empfänger (110), der dazu angeordnet ist, ein Oszillationssignal eines Oszillators und ein Referenzsignal, das ein Farbträgersignal eines gesendeten Fernsehsignals umfasst, zu empfangen; und
eine Steuerung (120), die dazu angeordnet ist, das Oszillationssignal innerhalb eines Frequenzbereichs zu ändern, um dem Referenzsignal zu entsprechen,
wobei die Steuerung dazu angeordnet ist, mindestens eine von einer Phase und einer Frequenz des empfangenen Oszillationssignals innerhalb des Frequenzbereichs zu ändern, um dem Referenzsignal zu folgen, sodass mindestens eine von der Phase und der Frequenz des Oszillationssignals mindestens einer von einer Phase und einer Frequenz des Referenzsignals entspricht, und
wobei die Steuerung dazu angeordnet ist, zu bestimmen, ob ein Fehler in dem Oszillator erzeugt wird oder nicht, indem sie einen einem Farbsignal entsprechenden Komponentenwert aus dem Referenzsignal auszieht und den Komponentenwert mit einem voreingestellten Wert vergleicht.

**2.** Fehlerdetektor nach Anspruch 1, wobei die Steuerung dazu angeordnet ist, die Änderung des Oszillationssignals abzubrechen, wenn eine Grenzzeit abläuft.

**3.** Fehlerdetektor nach einem der Ansprüche 1 bis 2, wobei die Steuerung dazu angeordnet ist, in einem Fall, in dem der Fehler in dem Oszillator vorhanden ist, einen Steuerbefehl zum Anzeigen einer entsprechenden graphischen Benutzeroberfläche GUI (Graphical User Interface) zu erzeugen.

4. Fehlerdetektor nach einem der Ansprüche 1 bis 3, wobei es sich bei dem Frequenzbereich um einen gemäß einer Benutzereingabe aus einer Vielzahl von Frequenzbereichen ausgewählten Frequenzbereich handelt.

5. Fehlerdetektor nach Anspruch 4, wobei die Steuerung dazu angeordnet ist, das Oszillationssignal des Oszillators in einer Reihenfolge von einem weiten Frequenzbereich zu einem engen Frequenzbereich innerhalb des ausgewählten Frequenzbereichs zu ändern, um dem Referenzsignal zu entsprechen.

6. Fehlerdetektor nach einem der Ansprüche 1 bis 5, wobei es sich bei dem Referenzsignal um ein Farbträgersignal eines Signals der Art NTSC (National Television System Committee) oder eines Signals der Art PAL (Phase Alternation by Line) handelt.

7. Fehlerdetektor nach einem der Ansprüche 1 bis 6, ferner umfassend einen Pegeldetektor (150), der dazu angeordnet ist, einen Ausgangspegel des empfangenen Oszillationssignals zu erfassen, wobei die Steuerung dazu angeordnet ist, in einem Fall, in dem der von der Pegelerfassungseinheit erfasste Ausgangspegel geringer als ein Grenzpegel ist, zu entscheiden, dass der Fehler in dem Oszillator erzeugt wird, und in einem Fall, in dem der von dem Pegeldetektor erfasste Ausgangspegel größer als oder gleich dem Grenzpegel ist, unter Verwendung des Frequenzbereichs zu bestimmen, ob der Fehler in dem Oszillator erzeugt wird oder nicht.

8. Fehlerdetektor nach einem der Ansprüche 1 bis 7, ferner umfassend einen Selektor (130), der dazu angeordnet ist, eines einer Vielzahl von Oszillationssignalen einer Vielzahl von Oszillatoren auszuwählen, wobei die Steuerung dazu angeordnet ist, den Empfänger dazu zu steuern, ein durch den Selektor aus der Vielzahl von Oszillatorsignalen ausgewähltes Signal zu empfangen.

9. Verfahren zum Erfassen eines Fehlers eines Oszillators, wobei das Verfahren Folgendes umfasst:

Empfangen eines Oszillationssignals des Oszillators und eines Referenzsignals, das ein Farbträgersignal eines gesendeten Fernsehsignals umfasst;
Ändern des Oszillationssignals innerhalb eines Frequenzbereichs, um dem Referenzsignal zu entsprechen; und
Bestimmen, ob ein Fehler in dem Oszillator erzeugt wird oder nicht, indem ein einem Farbsignal entsprechender Komponentenwert aus dem Referenzsignal ausgezogen wird und der Komponentenwert mit einem voreingestellten Wert verglichen wird,
wobei bei dem Ändern mindestens eine von einer Phase und einer Frequenz des empfangenen Oszillationssignals innerhalb des Frequenzbereichs geändert wird, um dem Referenzsignal zu folgen, sodass mindestens eine von der Phase und der Frequenz des Oszillationssignals mindestens einer von einer Phase und einer Frequenz des Referenzsignals entspricht.

10. Verfahren nach Anspruch 9, ferner umfassend das Abbrechen der Änderung des Oszillationssignals, wenn eine Grenzzeit abläuft.

11. Verfahren nach einem der Ansprüche 9 bis 10, ferner umfassend das Erzeugen eines Steuerbefehls zum Anzeigen einer entsprechenden GUI in einem Fall, in dem der Fehler in dem Oszillator vorhanden ist.

**Revendications**

1. Détecteur d'erreurs comportant :

un récepteur (110) agencé pour recevoir un signal d'oscillation d'un oscillateur et un signal de référence comportant un signal de sous-porteuse couleur d'un signal de télédiffusion ; et
un dispositif de commande (120) agencé pour changer le signal d'oscillation dans les limites d'une bande de fréquences de manière à correspondre au signal de référence,
dans lequel le dispositif de commande est agencé pour changer au moins l'une parmi une phase et une fréquence du signal d'oscillation reçu dans les limites de la bande de fréquences de manière à poursuivre le signal de référence de telle sorte qu'au moins l'une parmi la phase et la fréquence du signal d'oscillation correspond à au moins l'une parmi une phase et une fréquence du signal de référence, et
dans lequel le dispositif de commande est agencé pour déterminer si oui ou non une erreur est générée dans l'oscillateur par l'extraction d'une valeur de composante correspondant à un signal de couleur en provenance du signal de référence et par la comparaison de la valeur de composante par rapport à une valeur prédéfinie.

2. Détecteur d'erreurs selon la revendication 1, dans lequel le dispositif de commande est agencé pour arrêter le changement du signal d'oscillation quand une durée de seuil s'écoule.

3. Détecteur d'erreurs selon l'une quelconque des revendications 1 à 2, dans lequel le dispositif de commande est agencé pour générer une instruction de commande pour afficher une GUI (graphical user interface - interface utilisateur graphique) correspondante dans un cas de figure dans lequel l'erreur est présente dans l'oscillateur.

4. Détecteur d'erreurs selon l'une quelconque des revendications 1 à 3, dans lequel la bande de fréquences est une bande de fréquences sélectionnée parmi une pluralité de bandes de fréquences en fonction d'une entrée d'utilisateur.

5. Détecteur d'erreurs selon la revendication 4, dans lequel le dispositif de commande est agencé pour changer le signal d'oscillation de l'oscillateur selon une séquence allant d'une large bande de fréquences à une bande étroite de fréquences dans les limites de la bande de fréquences sélectionnée de manière à correspondre au signal de référence.

6. Détecteur d'erreurs selon l'une quelconque des revendications 1 à 5, dans lequel le signal de référence est un signal de sous-porteuse couleur d'un signal de type NTSC (national television system committee - comité du système de télévision nationale) ou d'un signal de type PAL (phase alternation by line - ligne d'alternance de phase).

7. Détecteur d'erreurs selon l'une quelconque des revendications 1 à 6, comportant par ailleurs un détecteur de niveau (150) agencé pour détecter un niveau de sortie du signal d'oscillation reçu,
dans lequel le dispositif de commande est agencé pour décider que l'erreur est générée dans l'oscillateur dans un cas de figure dans lequel le niveau de sortie détecté par l'unité de détection de niveau est inférieur à un niveau de seuil, et pour déterminer si oui ou non l'erreur est générée dans l'oscillateur en utilisant la bande de fréquences dans un cas de figure dans lequel le niveau de sortie détecté par le détecteur de niveau est supérieur ou égal au niveau de seuil.

8. Détecteur d'erreurs selon l'une quelconque des revendications 1 à 7, comportant par ailleurs un sélecteur (130) agencé pour sélectionner l'un d'une pluralité de signaux d'oscillation d'une pluralité d'oscillateurs,
dans lequel le dispositif de commande est agencé pour commander le récepteur pour recevoir un signal sélectionné parmi la pluralité de signaux d'oscillateurs par le biais du sélecteur.

9. Procédé servant à détecter une erreur d'un oscillateur, le procédé comportant les étapes consistant à :

recevoir un signal d'oscillation de l'oscillateur et un signal de référence comportant un signal de sous-porteuse couleur d'un signal de télédiffusion ;
changer le signal d'oscillation dans les limites d'une bande de fréquences de manière à correspondre au signal de référence ; et
déterminer si oui ou non une erreur est générée dans l'oscillateur par l'extraction d'une valeur de composante correspondant à un signal de couleur en provenance du signal de référence et par la comparaison de la valeur de composante par rapport à une valeur prédéfinie,
dans lequel dans l'étape consistant à changer, au moins l'une parmi une phase et une fréquence du signal d'oscillation reçu est changée dans les limites de la bande de fréquences de manière à poursuivre le signal de référence de telle sorte qu'au moins l'une parmi la phase et la fréquence du signal d'oscillation correspond à au moins l'une parmi une phase et une fréquence du signal de référence.

10. Procédé selon la revendication 9, comportant par ailleurs l'étape consistant à arrêter le changement du signal d'oscillation quand une durée de seuil s'écoule.

11. Procédé selon l'une quelconque des revendications 9 à 10, comportant par ailleurs l'étape consistant à générer une instruction de commande pour afficher une GUI correspondante dans un cas de figure dans lequel l'erreur est présente dans l'oscillateur.

# FIG. 1

100

110

120

RECEIVER ◄──────► CONTROLLER

# FIG. 2

100

110          130          140          150          120

RECEIVER ─► SELECTOR ─► ADC ─► LEVEL DETECTOR ◄──► CONTROLLER

160 ─── SRC

14

# FIG. 3

# FIG. 4

NTSC Color:
U*sin(wt) (+/-)Vcos(wt)

Oscillator 420

Demodulator 440

441

Reference
Signal
410

Burst Lock
SRC
430

freq

cos(freq)

(+/-)V

V phase
Accumulator

sin(freq)

U

U phase
Accumulator

Increment

Center
Frequency
Table
447

PI
Control
445

Limiter
443

Phase error

Spec selection
1. 50ppm
2. 100ppm
3. 160ppm
4. 180ppm

U sign is
negative
449

N

SPEC
OUT
452

Y

SPEC
IN
451

EP 3 002 875 B1

# FIG. 5

FREQUENCY
RANGE

REFERENCE SIGNAL
t

LOCK
t

UNLOCK
t

# FIG. 6

180  605 603 601

NTSC

U sin(wt) + V cos(wt)

U sin(wt) - V cos(wt)

U sin(wt) + V cos(wt)

# FIG. 7

```
                    ┌─────────────┐
                    │    START    │
                    └──────┬──────┘
                           │
            ┌──────────────▼──────────────┐
            │   RECEIVE OSCILLATION SIGNAL OF   │── S710
            │  OSCILLATOR AND REFERENCE SIGNAL  │
            └──────────────┬──────────────┘
                           │
            ┌──────────────▼──────────────┐
            │     SET FREQUENCY RANGE      │── S720
            └──────────────┬──────────────┘
                           │
            ┌──────────────▼──────────────┐
            │ CHANGE OSCILLATION SIGNAL WITHIN │── S730
            │      FREQUENCY RANGE SO AS TO     │
            │   CORRESPOND TO REFERENCE SIGNAL  │
            └──────────────┬──────────────┘
```

S740

DECIDE WHETHER OR NOT COLOR SIGNAL VALUE U EXTRACTED FROM REFERENCE SIGNAL IS NEGATIVE NUMBER AFTER THRESHOLD TIME ELAPSES

N

Y

S750

DECIDE THAT ERROR IS GENERATED IN OSCILLATOR

S760

DECIDE THAT OSCILLATOR IS NORMALLY OPERATED

END

# FIG. 8

START

RECEIVE REFERENCE SIGNAL AND SELECT
AND RECEIVE ONE OF OSCILLATION
SIGNALS OF A PLURALITY OF OSCILLATORS ── S810

CONVERT OSCILLATION SIGNAL
INTO DIGITAL SIGNAL ── S820

IS OUTPUT
LEVEL HIGHER THAN THRESHOLD ── S830
LEVEL?

N

Y

SET TRACKABLE FREQUENCY RANGE ── S840

CHANGE OSCILLATION SIGNAL WITHIN
FREQUENCY RANGE SO AS TO
CORRESPOND TO PHASE AND ── S850
FREQUENCY OF REFERENCE SIGNAL

S860

AFTER
THRESHOLD TIME ELAPSES,
IS OSCILLATION SIGNAL CHANGED
SO AS TO CORRESPOND
TO REFERENCE
SIGNAL?

Y          N

S870                                      S880

DECIDE THAT OSCILLATOR
IS NORMALLY OPERATED

GENERATE GUI FOR
NOTIFYING THAT ERROR IS
GENERATED IN OSCILLATOR

END

# FIG. 9

```
                        ┌─────────┐
                        │  START  │
                        └────┬────┘
                             │
              ┌──────────────▼──────────────┐
              │   RECEIVE OSCILLATION SIGNAL │
              │      OF OSCILLATOR AND       │───S910
              │       REFERENCE SIGNAL       │
              └──────────────┬──────────────┘
                             │
              ┌──────────────▼──────────────┐
              │       SET A PLURALITY OF     │───S920
              │       FREQUENCY RANGES       │
              └──────────────┬──────────────┘
                             │◄─────────────────────────────────────┐
              ┌──────────────▼──────────────┐                       │
              │    CHANGE OSCILLATION SIGNAL │                       │
              │   WITHIN WIDEST RANGE AMONG A│                       │
              │  PLURALITY OF FREQUENCY RANGES│──S930                │
              │   IN WHICH CHANGE OF OSCILLATION│                    │
              │  SIGNAL IS NOT ATTEMPTED, SO AS TO│                  │
              │   CORRESPOND TO REFERENCE SIGNAL │                   │
              └──────────────┬──────────────┘                       │
                             │         S940                 S950     │
                    ┌────────▼────────┐        ┌──────────────────┐ │
                    │   IS U EXTRACTED │        │    ARE CHANGES   │ │
                    │ FROM REFERENCE   │   Y    │  OF OSCILLATION  │N│
                    │ SIGNAL NEGATIVE  ├───────►│SIGNAL ATTEMPTED IN ALL├┘
                    │     VALUE?       │        │  OF SET FREQUENCY│
                    └────────┬────────┘        │      RANGES?     │
                             │N                 └────────┬─────────┘
                             │                           │Y
              ┌──────────────▼──────────────┐ ┌──────────▼─────────┐
              │      DECIDE THAT ERROR       │ │    DECIDE THAT     │
              │       IS GENERATED           │─│   OSCILLATOR IS    │─S970
              │      IN OSCILLATOR    S960   │ │  NORMALLY OPERATED │
              └──────────────┬──────────────┘ └──────────┬─────────┘
                             │                           │
                             └────────────┬──────────────┘
                             ┌────────────▼────────────┐
                             │  GENERATE GUI FOR REPRESENTING│─S980
                             │  DECIDED STATE OF OSCILLATOR  │
                             └────────────┬────────────┘
                                     ┌────▼────┐
                                     │   END   │
                                     └─────────┘
```

**EP 3 002 875 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4156255 A
- US 2004146132 A1